# EUROPÄISCHE PATENTANMELDUNG

(11) **EP 1 870 488 A1**
(43) Veröffentlichungstag der Anmeldung: **26.12.2007**
(21) Anmeldenummer: 06012961.6
(22) Anmeldetag: 23.06.2006
(51) Int. Cl.: C23C 14/56, C23C 14/54

(54) **Vorrichtung zur Beeinflussung des elektrostatischen Zustands einer Folie**

(71) Anmelder: Applied Materials GmbH & Co. KG, 63755 Alzenau (DE)
(72) Erfinder: KLEMM, Günter, D-61667 Nidda (DE); HACKER, Volker, D-63674 Altenstadt-Oberau (DE); LOTZ, Hans-Georg, D-63584 Gründau-Rothenbergen (DE)
(74) Vertreter: Schickedanz, Willi

(57) **Zusammenfassung**

Die Erfindung betrifft eine Vorrichtung zur Beeinflussung des elektrostatischen Zustands einer Kunststoff-Folie (1). Die Kunststoff-Folie ist um eine Kühlwalze (2) geschlungen, welche die Wärme aufnimmt, die bei einer Beschichtung der Kunststoff-Folie entsteht. Damit die Kunststoff-Folie fest an der Kühlwalze haftet, wird sie zunächst negativ elektrostatisch aufgeladen (7). Nach dem Verlassen der Kühlwalze wird die Kunststoff-Folie durch Aufbringen positiver Ionen (28) wieder elektrostatisch entladen.

## Beschreibung

Die Erfindung betrifft eine Vorrichtung nach dem Oberbegriff des Patentanspruchs 1.

Mit Metallschichten versehene Folien werden in verstärktem Maß bei der Herstellung von Kondensatoren verwendet. Diese Kondensatoren verdrängen immer mehr die keramischen und Elektrolyt-Kondensatoren. Als Grundmaterial für die Folien dient in der Regel Polypropylen, auf das beispielsweise mittels eines Sputter- oder Verdampferprozesses Metall aufgebracht wird (vgl. Peter Olbrich, Advanced Coating Technology for Film Capacitor Applications, CARTS ASIA 2005: 2nd Annual Capacitor and Resistor Symposium, October 11- 13, 2005).

Während des Beschichtungsprozesses erwärmen sich die Folien sehr stark. Um eine Überhitzung der Folien und damit ein Schmelzen zu vermeiden, werden die Folien über eine oder mehrere gekühlte Leitwalzen geführt (DE 44 38 675 A1).

Die Kühlung der Folien hängt sehr stark von der Haftung der Folie auf der Leitwalze ab. Die Haftung zwischen Folie und Leitwalze wird bei Beschichtungsanlagen für die Herstellung von Kondensatoren dadurch verbessert, dass man eine elektrische Spannung zwischen der aufgebrachten Metallschicht und der Leitwalze anlegt. Man nennt dieses Verfahren das BIAS-Verfahren (BIAS = Vorspannung).

Das BIAS-Verfahren hat indessen den Nachteil, dass es nicht sicher und kontinuierlich wirkt, weil bei elektrischen Kurzschlüssen die Haftung zwischen Folie und Walze sofort aufgehoben wird. Solche Kurzschlüsse treten jedoch relativ häufig auf, z. B. dann, wenn während des Aufdampfprozesses Spritzer auftreten, welche die Folie durchschlagen oder durchbrennen. Zwischen der Metallschicht der Folie und der Leitwalze entsteht dann ein elektrischer Kurzschluss. Dadurch werden die Folien weniger gekühlt und durch thermische Überhitzung unbrauchbar. In manchen Fällen reißt die Folie, und der Prozess muss unterbrochen und die Beschichtungsanlage geöffnet werden.

Ein weiterer Nachteil des BIAS-Verfahrens besteht darin, dass bei neueren Kondensatorbeschichtungen oft keine durchgängigen Metallschichten auf der Folie aufgebracht werden, sondern z. B. rautenförmige Metallmuster, die nur ggf. durch kleine Metallstege miteinander verbunden sind. Da die elektrische Zugkraft nur an den metallischen Rauten und Stegen auftritt, nimmt sie insgesamt ab.

Es ist bereits ein Verfahren bekannt, um das Einrollen einer aufgedampften Kupferschicht zu verhindern, wobei die Schicht mittels elektrostatischer Kräfte auf einem Substrat befestigt wird (JP 62124269 A). Die elektrostatischen Kräfte werden hierbei mittels negativer oder positiver Ladungen aufgebracht. Eine bessere Verbindung zwischen Kühlwalzen und Folien ist nicht angesprochen.

Weiterhin ist es bekannt, elektrische Ladungen auf einer beschichteten Kunststofffolie zu beseitigen (JP 02023528 A). Hierbei werden auf die Beschichtung Ionen oder Elektronen aufgebracht. Eine Haftungsverbesserung zwischen Kühlwalzen und beschichteten Folien ist nicht angesprochen.

Außerdem ist ein Verfahren zum kontinuierlichen Beschichten von nicht leitenden Folien bekannt, bei dem die Folie während ihrer Auflage an einer Kühlwalze vor dem Beschichten einem Elektronenbeschuss durch einen thermischen Emitter mit einer Spannung zwischen 3 und 10 kV, vorzugsweise zwischen 4 und 8 kV, ausgesetzt wird (DE 42 27 873 A1).

Ein anderes bekanntes Verfahren für die Herstellung eines Dünnfilms enthält folgende Schritte: Bewegen eines Polymerfilms in Umfangsrichtung auf einer Mantelfläche eines zylindrischen Bechers, Aufbringen von Elektronen von einer Elektronenkanone auf den Polymerfilm während der Bewegung des Polymerfilms, nachfolgendes Aufbringen eines Dünnfilms auf den Polymerfilm mittels Vakuumverdampfens und Aufbringen von Ionen und Elektronen von einer ersten Ionenkanone auf den Polymerfilm, und zwar stromaufwärts des Elektronenaufbringens (EP 0 387 904 B1). Auch bei diesem Verfahren geht es nicht um die Erhöhung des Anpressdrucks einer Folie auf eine Kühlwalze.

Es ist ferner ein Verfahren zum Elektronenaufheizen bei einer Dampfbeschichtungsanlage bekannt, mit dem eine Folie auf eine Kühlwalze gedrückt wird (JP 06002117 A). Hierbei wird eine elektrostatische Ladung gleichmäßig während des Beschichtungsvorgangs auf die Folie aufgebracht.

Schließlich ist ein weiteres Verfahren für die Vakuumbeschichtung von Folien bekannt, bei dem die Sekundärelektronen, die durch ein Verdampfungsmaterial auf dem Substrat auftreten, elektrisch neutralisiert werden (JP 2000313953 A).

Der Erfindung liegt die Aufgabe zugrunde, das Haften einer zu beschichtenden Folie auf einer Kühlwalze zu verbessern, ohne dass die Nachteile des BIAS-Verfahrens auftreten.

Diese Aufgabe wird gemäß den Merkmalen des Patentanspruchs 1 gelöst.

Die Erfindung betrifft somit eine Vorrichtung zur Beeinflussung des elektrostatischen Zustands einer Folie. Die Folie ist bei einer bevorzugten Ausführungsform um eine Kühlwalze geschlungen, welche die Wärme aufnimmt, die bei einer Beschichtung der Folie entsteht. Damit die Folie fest an der Kühlwalze haftet, wird sie zunächst negativ elektrostatisch aufgeladen. Nach dem Verlassen der Kühlwalze wird die Folie durch Aufbringen positiver Ionen wieder elektrostatisch entladen.

Der mit der Erfindung erzielte Vorteil besteht insbesondere darin, dass das Auf- und Entladen der Kunststofffolie ein aufeinander abgestimmtes geregeltes System bildet.

Ein Ausführungsbeispiel der Erfindung ist in den Zeichnungen dargestellt und wird im Folgenden näher beschrieben. Es zeigen:
- Fig. 1: eine Prinzipdarstellung der erfindungsgemäßen Vorrichtung;
- Fig. 2: eine erfindungsgemäße Elektronenquelle;
- Fig. 3: einen Querschnitt durch eine Elektronenquelle;
- Fig. 4: eine perspektivische Darstellung einer Elektronenquelle mit Blende.

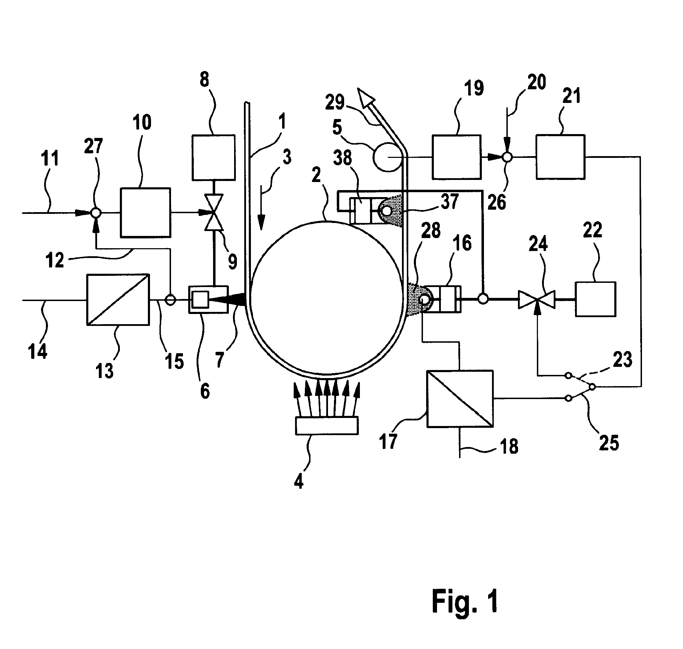

In Fig. 1 ist eine zu beschichtende Kunststoff-Folie 1 um eine Kühl- und Beschichtungswalze 2 geschlungen, die sich in Richtung eines Pfeils 3 um diese Kühlwalze 2 bewegt. Unterhalb der Kühlwalze 2 befindet sich ein Verdampfer 4, in dem Material, beispielsweise Metall verdampft wird, das anschließend auf die Kunststoff-Folie 1 gelangt. Die beschichtete Kunststoff-Folie 1 wird dann über eine Messwalze 5 geführt und gelangt von dort an eine nicht dargestellte Aufwickeltrommel, wo sie aufgewickelt wird.

Damit die Kunststoff-Folie 1 während der Beschichtung fest an der Kühlwalze 2 haftet, werden aus einer linearen Elektronenquelle 6 Elektronen 7 auf die Kunststoff-Folie 1 gegeben, die sich hierauf elektrostatisch auflädt und dadurch fest an der Kühlwalze 2 haftet.

Der Gaszufluss, mit dem der Elektronenstrom beeinflusst wird, erfolgt aus einem Gasbehälter 8, der über ein steuerbares Ventil 9 mit der Elektronenquelle 6 in Verbindung steht. Das Ventil 9 wird seinerseits von einem Regler 10 gesteuert, der mit der Differenz zwischen einem Elektronenstrom-Sollwert 11 und einem Elektronenstrom-Istwert 12 beaufschlagt wird. Diese Differenz wird mittels eines Vergleichers 27 ermittelt. Mit 13 ist ein Wandler bezeichnet, der einen Netzwechselstrom 14 hochtransformiert und in einen Gleichstrom 15 umformt. Der von der Elektronenquelle 6 angeforderte Gleichstrom ist proportional zum Elektronenstrom der Elektronenstrahlquelle 6. Die Ausgangsspannung des Wandlers 13 ist regelbar, sodass auch die Energie der Elektronen und damit ihre Austrittsgeschwindigkeit regelbar sind.

Die Kunststoff-Folie 1 ist nach ihrer Beschichtung aus dem Verdampfer 4 weiterhin elektrisch stark aufgeladen. Diese Aufladung ist jedoch für die weitere Bearbeitung der Kunststoff-Folie 1 unerwünscht. Daher ist es erforderlich, die Kunststoff-Folie 1 nach der Beschichtung zu entladen. Für die Entladung der Kunststoff-Folie ist eine lineare Plasma-Ionen-Quelle 16 vorgesehen, die mit einem elektrischen Wandler 17, der aus dem Wechselstromnetz 18 gespeist wird, verbunden ist. Durch die positiven Ionen der Plasma-Ionen-Quelle 16 wird die Oberfläche der Kunststoff-Folie 1 elektrostatisch neutralisiert, indem die positiven Ionen die an der Oberfläche der Kunststoff-Folie 1 haftenden Elektronen aufnehmen.

In der Fig. 1 ist eine Plasma-Ionen-Quelle 16 dargestellt, die Ionen auf die MetallBeschichtung der Kunststofffolie 1 abgibt. Vorteilhafter ist es jedoch, eine Plasma-Ionen-Quelle 38 vorzusehen, die Ionen 37 auf die unbeschichtete Seite 29 der Kunststoff-Folie 1 abgibt. Die lineare Plasma-Ionenquelle 16, 38 kann durch mehrere nebeneinander angeordnete quasi-punktförmige Quellen realisiert werden.

Mit Hilfe der Messwalze 5 wird der Ladezustand der Kunststoff-Folie 1 ermittelt. Die mittels der Messwalze 5 von der nicht beschichteten Seite der Kunststoff-Folie 1 abgegriffene Spannung, welche den Istwert der Ladung repräsentiert, wird einem Verstärker 19 zugeführt und mit einem vorgegebenen Sollwert 20 verglichen. Die Differenz zwischen Soll- und Istwert wird durch einen Vergleicher 26 ermittelt und auf einen Regler 21 gegeben, der das aus einem Behälter 22 zur Plasma-Ionen-Quelle 16 gelangende Gas über einen Schalter 23 und ein Ventil 24 regelt. Statt des Gasflusses kann der Regler 21 aber auch über einen Schalter 25 die Leistung des elektrischen Wandlers 17 regeln.

In der Regel wird angestrebt, durch den geregelten Ionenstrahl 28 die Ladung auf der Kunststoff-Folie 1 komplett zu neutralisieren, sodass die Spannung nach der Neutralisierung 0 Volt beträgt. Es hat sich jedoch erwiesen, dass - abhängig vom jeweiligen Material der Kunststoff-Folie 1 - auch eine von Null abweichende Spannung erforderlich sein kann.

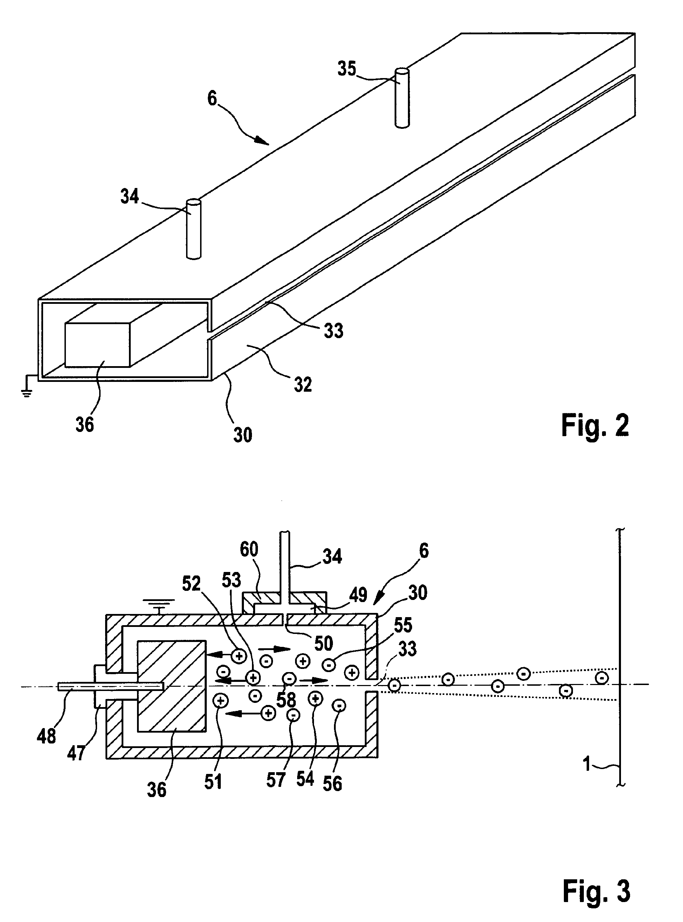

In der Fig. 2 ist die bei der Erfindung bevorzugt verwendete Elektronenquelle 6 näher dargestellt.

Diese Elektronenquelle 6 weist ein Gehäuse 30 auf, in dem sich eine stabförmige Kathode 36 befindet, die auf Hochspannungspotential gelegt ist. In dieses Gehäuse 30 wird über zwei Zugänge 34, 35 Argon eingelassen, sodass sich eine Glimmentladung ausbildet. Die hierbei entstehenden Elektronen werden von dem an Masse liegenden Gehäuse 30 zur Frontseite 32 dieses Gehäuses 30 beschleunigt und treten durch einen Schlitz 33 aus, der sich in der Frontseite 32 des Gehäuses 30 gegenüber der Stabkathode 36 befindet. Durch Variation des Argon-Flusses ist der Elektronenstrom veränderbar. Die Energie der Elektronen verändert sich mit der Höhe des angelegten elektrischen Potentials.

Das auf Massepotential liegende Gehäuse 30 wird mit Wasser über nicht dargestellte Kühlrohre gekühlt, während die auf Hochspannung liegende Kathode 36 indirekt über thermischen Kontakt durch eine in der Fig. 2 nicht dargestellte Isolierkeramik, die zwischen Kathode 36 und Gehäuse 30 liegt, ebenfalls gekühlt wird. Die Zuführung der Hochspannung zum Gehäuse 30 von außen in den Vakuumbereich der Beschichtungsanlage ist im Einzelnen nicht dargestellt.

Die Elektronenquelle 6 kann an verschiedenen Stellen im Innern der Beschichtungsanlage positioniert werden, wodurch es möglich ist, die Kunststoff-Folie 1 an verschiedenen Stellen des Einlaufs auf die Kühlwalze 2 mit Elektronen zu beschießen. Am wirksamsten ist die Folienaufladung an der Stelle, wo die Kunststoff-Folie 1 auf die Kühlwalze 2 aufläuft.

Die Plasma-Ionenquelle 16, 38 kann ebenfalls an jeder Stelle der Beschichtungsanlage angeordnet werden. Ihre bevorzugte Anordnung ist unterhalb der Messwalze 5, wie es die Plasma-Ionenquelle 38 in Fig. 1 zeigt. In der Praxis sind noch mehrere Walzen vorhanden, die in der Fig. 1 jedoch nicht dargestellt sind. Als Messwalze wird in der Regel die letzte Walze vor der in Fig. 1 nicht gezeigten Aufwickelrolle verwendet.

Bei der Plasma-Ionenquelle 16, 38 handelt es sich vorzugsweise um eine lineare Ionenquelle, die über die ganze Breite oder nahezu über die ganze Breite der Kunststoff-Folie 1 positive Ionen abgibt.

Die Fig. 3 zeigt einen Querschnitt durch die lineare Elektronenquelle 6 der Fig. 1. Ein Hochspannungskabel 48 ist hierbei durch einen Stützisolator 47 zu der stabförmigen Kathode 36 geführt. Die Kathode 36 verläuft in die Zeichenebene hinein und ist etwa ebenso groß, wie die Kunststoff-Folie 1 oder der Schlitz 33 breit ist. Um das Sputtern oder Abtragen des Stabs 48 zu verhindern oder stark zu verringern, wird er aus VA-Stahl, Titan, Graphit oder CFC (= Carbon Fiber-Reinforced Carbon, z. B. Sigrabond 1001 G, vgl. Katalog der SGL Carbon Group vom Mai 2004, Werner-von-Siemens-Strasse 18, D-86405 Meitingen) hergestellt. Bei CFC handelt es sich um ein Material, das aus einer Kohlenstoff- oder Graphit-Matrix besteht, die mit Kohlenstofffasern verstärkt ist.

Der vorzugsweise aus Keramik bestehende Stützisolator 47 dient auch als Abstützung der Kathode 36 gegenüber dem auf Massepotential liegenden Gehäuse 30. Außerdem mündet der Gaszugang 34 nicht direkt - wie in Fig. 1 dargestellt - in das Gehäuse 30, sondern in einen Puffer-Raum 49, an den sich eine Öffnung 50 im Gehäuse 30 anschließt. Der Puffer-Raum 49 wird durch ein U-förmiges Teil 60 gebildet.

Das durch den Gaszugang 34 und den Puffer-Raum 49 gelangende Gas, z. B. Argon, wird durch die Öffnung 50 in das Innere des Gehäuses 30 eingegeben. Dort wird es bei einem Umgebungsdruck von ca. 1 x 10⁻² mbar und bei einer angelegten Gleichspannung von 3,0 bis 12,0 kV, die an der Kathode 36 liegt, ionisiert, und zwar in der Nähe der Kathode 36. Die positiven Ionen 51 bis 54 werden dabei zur elektrisch negativen Kathode 36 hin beschleunigt, während die Elektronen 55 bis 58 auf das an Masse liegende Gehäuse 30 beschleunigt werden. Einige dieser Elektronen 55 bis 58 gelangen zum Spalt 33 und von dort im Wesentlichen geradlinig auf die Kunststoff-Folie 1.

Eine Regelung des Elektronenstroms kann - wie bereits erwähnt - über den Gaszufluss erfolgen. Es ist aber auch möglich, eine solche Regelung allein über die Hochspannungsversorgung vorzunehmen. Auch über eine Kombination von Gaszufluss und Hochspannung kann eine Regelung des Elektronenstroms erfolgen.

Bei der Elektronenquelle 6 handelt es sich vorzugsweise um ein wassergekühltes rechteckiges Gehäuse 30 aus Kupfer, bei welchem die Kathode 36 isoliert angebracht ist.

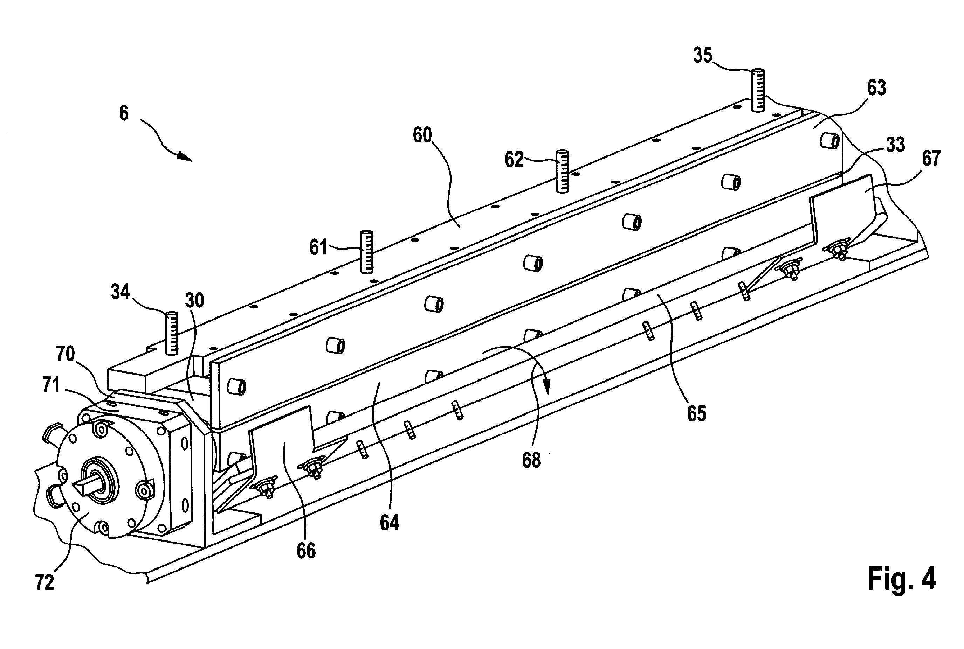

In der Fig. 4 ist die Elektronenquelle 6 noch einmal in einer perspektivischen Ansicht dargestellt, wobei man auch eine Blende erkennt, die in den Fig. 2 und 3 nicht dargestellt ist. Man erkennt hierbei das U-förmige Teil 60, in das insgesamt vier Gaszuführungen 34, 61, 62 und 35 eintreten. Der Schlitz 33 wird durch zwei Frontplatten 63, 64 gebildet, die Teil des Gehäuses 30 sind. Vor dem Schlitz 33 befindet sich eine schwenkbare und wassergekühlte Blende 65, die dazu dient, hitzeempfindliche Folien zu schützen. Die Blende 65 ist an ihren Enden mit nach oben gerichteten Flanschen 66, 67 versehen.

In der Fig. 4 ist die Blende 65 teilweise geöffnet. Wird sie ganz geöffnet, d. h. in Richtung des Pfeils 68 nach unten geklappt, können die Elektronen durch den Schlitz 33 frei auf die Kunststoff-Folie 1 gelangen. Die seitlichen Flansche 66, 67 verhindern in dieser Position jedoch den freien Flug der Elektronen zu der Kunststoff-Folie. Mit Hilfe dieser Flansche 66, 67 wird eine exakte seitliche Begrenzung der bestrahlten Fläche erzielt.

Wird die Blende 65 entgegen der Richtung des Pfeils 68 nach oben geklappt, gelangen keine Elektronen mehr auf die Kunststoff-Folie.

Mit 70 bis 72 sind Teile eines "Mechanismus" bezeichnet, mit dem die Blende bewegt werden kann. Der Elektronenstrom kann sowohl über den Gaszufluss als auch über die Amplitude der Hochfrequenzspannung geregelt werden.

Die Regelung des Elektronenstroms über den Gasfluss kann nicht nur direkt über ein Ventil erfolgen, sondern ist auch mit einem zwischengeschalteten Druckregler möglich.

Ein Vorteil der Elektronenquelle 6 besteht darin, dass sie einfach und kompakt aufgebaut ist. Dadurch kann sie leicht an verschiedenen Stellen einer Beschichtungsanlage eingebaut werden. Sie weist nur wenige Teile von einfacher geometrischer Form auf und ist sehr leicht an unterschiedliche Substratbreiten anzupassen.

## Patentansprüche

1. Vorrichtung zur Beeinflussung des elektrostatischen Zustands einer Folie oder dergleichen, mit einer ersten Teilchenquelle (6), die eine Menge von Teilchen einer ersten Polarität an einer ersten Stelle der Folie (1) auf die Folie (1) abgibt, und mit einer zweiten Teilchenquelle (16), die eine Menge von Teilchen einer zweiten Polarität an einer zweiten Stelle der Folie (1) auf die Folie (1) abgibt, **gekennzeichnet durch**
a) ein Ladungsmessgerät (5), das hinter der zweiten Teilchenquelle (16) vorgesehen ist und die auf der Folie (1) befindliche Ladung misst und
b) einen Regler (21), der den Teilchenstrom und/oder die Teilchenenergie der zweiten Teilchenquelle (16) regelt.

2. Vorrichtung nach Anspruch 1, **dadurch gekennzeichnet, dass** die Folie (1) eine Beschichtungswalze (2) um einen vorgegebenen Winkel umschlingt.

3. Vorrichtung nach Anspruch 1, **dadurch gekennzeichnet, dass** das Ladungsmessgerät (5) ein Spannungsmessgerät ist.

4. Vorrichtung nach Anspruch 3, **dadurch gekennzeichnet, dass** ein Vergleicher (26) vorgesehen ist, der die Spannung des Ladungsmessgeräts (5) mit einer Sollwertspannung (20) vergleicht und dem Regler (21) zuführt.

5. Vorrichtung nach den Ansprüchen 1 bis 4, **dadurch gekennzeichnet, dass** der Ausgang des Reglers (21) mit einem Gasventil (24) verbunden ist, das seinerseits einen Gasbehälter (22) mit der zweiten Teilchenquelle (16) verbindet.

6. Vorrichtung nach den Ansprüchen 1 bis 4, **dadurch gekennzeichnet, dass** der Ausgang des Reglers (21) mit einem elektrischen Wandler (17) verbunden ist, der seinerseits mit der zweiten Teilchenquelle (16) verbunden ist.

7. Vorrichtung nach Anspruch 1, **dadurch gekennzeichnet, dass** die erste Teilchenquelle (6) über ein steuerbares Ventil (9) mit einem Gasbehälter (8) verbunden ist.

8. Vorrichtung nach Anspruch 1, **dadurch gekennzeichnet, dass** die erste Teilchenquelle (6) mit einer Spannungsquelle (13) verbunden ist.

9. Vorrichtung nach Anspruch 7, **dadurch gekennzeichnet, dass** das Ventil (9) durch einen Regler (10) gesteuert wird, der von einem Vergleicher (27) das Differenzsignal aus einem Ist- und einem Sollstrom erhält.

10. Vorrichtung nach Anspruch 1, **dadurch gekennzeichnet, dass** das Ladungsmessgerät (5) in eine Walze (5) integriert ist, über die die Folie (1) läuft.

11. Vorrichtung nach den Ansprüchen 1 und 2, **dadurch gekennzeichnet, dass** die erste Stelle diejenige Stelle ist, an welcher die einlaufende Folie (1) die Walze (2) zum ersten Mal berührt.

12. Vorrichtung nach den Ansprüchen 1 und 2, **dadurch gekennzeichnet, dass** die zweite Stelle diejenige Stelle ist, an welcher die auslaufende Folie (1) die Walze (2) verlässt.

13. Vorrichtung nach den Ansprüchen 1, 7 oder 8, **dadurch gekennzeichnet, dass** die erste Teilchenquelle (6) eine Elektronenquelle ist und ein Gehäuse (30) mit einem Schlitz (33) auf einer Frontseite (32) aufweist sowie eine stabförmige Elektrode (31) enthält.

14. Vorrichtung nach Anspruch 1, **dadurch gekennzeichnet, dass** die zweite Teilchenquelle (16) eine lineare Ionenquelle ist.

15. Vorrichtung nach Anspruch 1 oder Anspruch 14, **dadurch gekennzeichnet, dass** die zweite Teilchenquelle (16) derart angeordnet ist, dass ihre ionisierten Teilchen auf die nicht beschichtete Seite der Folie (1) gelangen.

16. Vorrichtung nach Anspruch 13, **dadurch gekennzeichnet, dass** eine schwenkbare Blende (65) vorgesehen ist, welche den Schlitz (33) abdecken oder freigeben kann.

17. Vorrichtung nach Anspruch 16, **dadurch gekennzeichnet, dass** die Blende (65) an ihren Enden Flansche (66, 67) aufweist, die in jeder Position aus dem Schlitz (33) kommende Elektronen in Richtung auf das Substrat (1) absperren.

18. Vorrichtung nach Anspruch 13, **dadurch gekennzeichnet, dass** die stabförmige Elektrode (31) aus CFC besteht.

## Geänderte Patentansprüche

### Geänderte Patentansprüche gemäss Regel 137(2) EPÜ.

**1.** Vorrichtung zur Beeinflussung des elektrostatischen Zustands einer Kunststofffolie (1), **gekennzeichnet durch**
a) eine Kühlwalze (2) zur Führung der Kunststofffolie (1),
b) einen Verdampfer (4) in einem Abstand von der Kühlwalze (2), dessen verdampfte Teilchen sich auf der Außenseite der Kunststofffolie (1) niederschlagen,
c) eine lineare Elektronenquelle (6), welche die Kunststofffolie (1) mit Elektronen beaufschlagt, bevor sich die verdampften Teilchen auf der Kunststofffolie (1) niederschlagen,
d) eine lineare Ionenquelle (38), welche die unbeschichtete Innenseite der Kunststofffolie (1) mit positiven Ionen beaufschlagt, nachdem sich auf der Außenseite der Kunststofffolie (1) die verdampften Teilchen auf der Kunststofffolie (1) niedergeschlagen haben,
e) ein Ladungsmessgerät (5), das, in Laufrichtung der Kunststofffolie gesehen, hinter der linearen Ionenquelle (38) vorgesehen ist und die auf der Kunststofffolie (1) befindliche elektrische Ladung misst,
f) einen Regler (21), dem das Differenzsignal zwischen der gemessenen Ladung und einem Ladungssollwert zugeführt ist und der den Ionenstrom und/oder die Energie der Ionen der Ionenquelle (16) regelt.

**2.** Vorrichtung nach Anspruch 1, **dadurch gekennzeichnet, dass** die Kunststofffolie (1) die Kühlwalze (2) um einen vorgegebenen Winkel umschlingt.

**3.** Vorrichtung nach Anspruch 1, **dadurch gekennzeichnet, dass** das Ladungsmessgerät (5) ein Spannungsmessgerät ist.

**4.** Vorrichtung nach Anspruch 1, **dadurch gekennzeichnet, dass** der Ausgang des Reglers (21) mit einem Gasventil (24) verbunden ist, das seinerseits einen Gasbehälter (22) mit der Ionenquelle (16) verbindet.

**5.** Vorrichtung nach Anspruch 1, **dadurch gekennzeichnet, dass** der Ausgang des Reglers (21) mit einem elektrischen Wandler (17) verbunden ist, der seinerseits mit der Ionenquelle (16) verbunden ist.

**6.** Vorrichtung nach Anspruch 1, **dadurch gekennzeichnet, dass** die Elektronenquelle (6) über ein steuerbares Ventil (9) mit einem Gasbehälter (8) verbunden ist.

**7.** Vorrichtung nach Anspruch 1, **dadurch gekennzeichnet, dass** die Elektronenquelle (6) mit einer Spannungsquelle (13) verbunden ist.

**8.** Vorrichtung nach Anspruch 6, **dadurch gekennzeichnet, dass** das steuerbare Ventil (9) durch einen Regler (10) gesteuert wird, der von einem Vergleicher (27) das Differenzsignal aus einem Ist- und einem Sollstrom erhält.

**9.** Vorrichtung nach Anspruch 1, **dadurch gekennzeichnet, dass** das Ladungsmessgerät (5) in eine Walze (5) integriert ist, über die die Kunststofffolie (1) läuft.

**10.** Vorrichtung nach Anspruch 1, **dadurch gekennzeichnet, dass** die Elektronenquelle (38) dort angeordnet ist, wo die einlaufende Kunststofffolie (1) die Walze (2) zum ersten Mal berührt.

**11.** Vorrichtung nach Anspruch 1, **dadurch gekennzeichnet, dass** die lineare Ionenquelle (38) dort angeordnet ist, wo die auslaufende Kunststofffolie (1) die Walze (2) verlässt.

**12.** Vorrichtung nach Anspruch 1, **dadurch gekennzeichnet, dass** die Elektronenquelle (6) ein Gehäuse (30) mit einem Schlitz (33) auf einer Frontseite (32) aufweist sowie eine stabförmige Elektrode (31) enthält.

**13.** Vorrichtung nach Anspruch 12, **dadurch gekennzeichnet, dass** eine schwenkbare Blende (65) vorgesehen ist, welche den Schlitz (33) abdecken oder freigeben kann.

**14.** Vorrichtung nach Anspruch 13, **dadurch gekennzeichnet, dass** die Blende (65) an ihren Enden Flansche (66, 67) aufweist, die in jeder Position aus dem Schlitz (33) kommende Elektronen in Richtung auf das Substrat (1) absperren.

**15.** Vorrichtung nach Anspruch 12, **dadurch gekennzeichnet, dass** die stabförmige Elektrode (31) aus CFC besteht.
